# EUROPEAN PATENT SPECIFICATION

(11) **EP 3 273 530 B1**
(45) Date of publication and mention of the grant of the patent: **01.09.2021**
(21) Application number: 17181406.4
(22) Date of filing: 14.07.2017
(51) Int. Cl.: H01Q 1/24, H01Q 9/42

(54) **METAL COVER AND ELECTRONIC DEVICE**
METALLABDECKUNG UND ELEKTRONISCHE VORRICHTUNG
DISPOSITIF D'IMAGERIE ET DISPOSITIF ÉLECTRONIQUE

(30) Priority: 21.07.2016 WO PCT/CN2016/090860
(43) Date of publication of application: 24.01.2018
(73) Proprietor: Beijing Xiaomi Mobile Software Co., Ltd., Beijing 100085 (CN)
(72) Inventor: KUANG, Wei, Beijing, Beijing 100085 (CN); LIU, Wendong, Beijing, Beijing 100085 (CN); PI, Xiaohui, Beijing, Beijing 100085 (CN)
(74) Representative: dompatent von Kreisler Selting Werner - Partnerschaft von Patent- und Rechtsanwälten mbB

(56) References cited:
- CN-A- 105 244 598
- US-A1- 2008 165 071
- US-A1- 2015 057 054

## Description

### FIELD

The present disclosure relates to the field of terminal technology, and more particularly to a metal cover and an electronic device.

### BACKGROUND

Due to good metal texture, hand feeling, beautiful looking and cost advantages, all-metal covers are used more and more in smartphones. All-metal cover will shield signals received or radiated by an antenna, while a wider and wider signal bandwidth is needed to be supported by a smartphone for wireless communication, and there is also a need for openings in an antenna area of the smartphone to contain a Universal Serial Bus (USB) interface, a fingerprint identification sensor and main keys, etc., and therefore a large area of metal gap-crossing will exist in a metal cover. Since the all-metal cover is very thin, a distance between the all-metal cover and the gap-crossing is very small, strong coupling is formed between the all-metal cover and the gap-crossing, and an equivalent parasitic capacitor appears, which may cause a reduction of a signal radiation of the antenna of the smartphone in some frequency bands.

CN 105 244 598 A provides an antenna system and a mobile terminal. The antenna system comprises a metal housing arranged on the back of the mobile terminal; a gap provided in the metal housing in a first direction, and the gap divides the metal housing into an antenna portion and a grounding portion; wherein the antenna portion is connected with a feed source, the feed source is connected to an end area of the first end of the antenna portion in the first direction, and the feed source is connected with the grounding portion; the antenna system further comprises a first lead connected to the antenna portion and connected to the end area of the first end, a second lead connected to the antenna portion, and at least one adjustor connected with the first lead and/or the second lead and connected with the grounding portion. According to the scheme, the feed source is arranged at the end of the antenna portion, so that the antenna system has good performance; meanwhile, the leads for adjusting the bandwidth of the antenna system are increased, so that the antenna system has wider coverage bandwidth.

### SUMMARY

To solve at least one of the problems existing in the related art to at least some extent, embodiments of the present disclosure provide a metal cover and an electronic device for improving an influence of a metal gap on an antenna.

According to a first aspect of embodiments of the present disclosure, a metal cover is provided, the metal cover includes:
a metal body and an antenna radiator,
a gap provided between the metal body and the antenna radiator,
at least one ground point being provided on the metal body, and the antenna radiator being electrically connected to the at least one ground point, and
an opening formed in an area where the antenna radiator is located and configured for receiving a metallic component of an electronic device, wherein when the metal cover is assembled to the electronic device, the metallic component is located inside the metal cover and at a distance from the gap to form a gap-crossing at the gap, such that a parasitic capacitor is formed,
wherein a first energy storage element, a second energy storage element and/or a wire stretched across the gap is disposed between a respective one of the at least one ground point and the antenna radiator so as to reduce the influence of the parasitic capacitor on an operating band of the antenna radiator, and
each of the first energy storage element, the second energy storage element and/or the wire is directly electrically connected between a respective one of the at least one ground point and the antenna radiator.

In an embodiment, any combination of the first energy storage element, the second energy storage element, and the wire stretched across the gap are parallelly connected with each other.

In an embodiment, a parameter of the first energy storage element is determined by a capacitance value of a parasitic capacitor between the metal body and the antenna radiator.

In an embodiment, the first energy storage element is a capacitor or an inductor.

In an embodiment, the second energy storage element is a capacitor or an inductor, and the capacitor or the inductor is electrically connected to a respective one of the at least one ground point and the antenna radiator.

In an embodiment, the metallic component is a USB interface or a fingerprint identification sensor.

In an embodiment, the metal cover is the cover of an electronic device, and the electronic device further includes:
a processor; and
a memory for storing instructions executable by the processor.

The technical solutions provided by embodiments of the present disclosure may have following advantageous effects.

By setting at least one ground point on the metal body and electrically connecting the antenna radiator to the at least one ground point, the parasitic capacitor, the metal body and the antenna radiator may form a circuit loop, and thus the influence of the parasitic capacitor on the antenna radiator may be counteracted, the influence of the parasitic capacitor on the antenna radiator in certain frequency bands may be reduced and the performance of the antenna radiator is improved.

It should be appreciated that the general description above and the following detailed description are just exemplary and illustrative, thus should not be seen as any restriction to the present disclosure.

### BRIEF DESCRIPTION OF THE DRAWINGS

The accompanying drawings, which are incorporated in and constitute a part of this specification, illustrate embodiments consistent with the disclosure and, together with the description, serve to explain the principles of the disclosure.
Fig. 1 is a perspective view of a metal cover according to an example embodiment.
Fig. 2A is a schematic diagram showing a structure of a metal cover according to an example embodiment.
Fig. 2B is a schematic diagram showing an equivalent circuit of a metal cover according to an example embodiment.
Fig. 3 is a schematic diagram showing an equivalent circuit of a metal cover according to another example embodiment.
Fig. 4 is a schematic diagram showing an equivalent circuit of a metal cover according to yet another example embodiment.
Fig. 5 is a schematic diagram showing an equivalent circuit of a metal cover according to yet another example embodiment.
Fig. 6 is a schematic diagram showing an equivalent circuit of a metal cover according to yet another example embodiment.
Fig. 7 is a schematic diagram showing an equivalent circuit of a metal cover according to yet another example embodiment.
Fig. 8 is a schematic diagram showing performance curves of an antenna when the present disclosure is not used according to an example embodiment.
Fig. 9 is a schematic diagram showing performance curves of an antenna when the present disclosure is used according to an example embodiment.
Fig. 10 is a block diagram showing an electronic device according to an example embodiment.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the disclosure. Instead, they are merely examples of apparatuses and methods consistent with aspects related to the disclosure as recited in the appended claims.

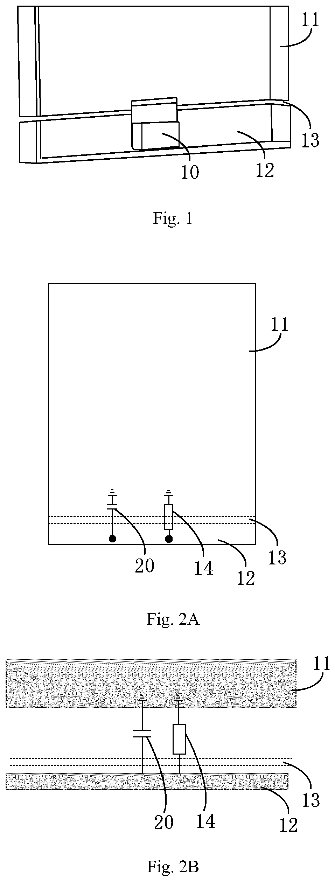

Fig. 1 is a perspective view of a metal cover according to an example embodiment. The metal cover can be used in an electronic device (for example, smartphone, a panel computer, etc.) as a housing of the electronic device. As shown in Fig. 1, the metal cover includes a metal body 11 and an antenna radiator 12, and a gap 13 is opened between the metal body 11 and the antenna radiator 12. There are openings for containing a USB interface 10, a fingerprint identification sensor (not shown) and an icon of the smartphone (not shown) opened in the area where the antenna radiator 12 is located. Taking the USB interface 10 as an example for illustrating, when the USB interface 10 is contained in the opening, the USB interface 10 will form a gap-crossing at the gap 13. When the distance from the gap 13 in the thickness direction of the electronic device is less than a predetermined distance (the predetermined distance can be determined by the thickness of the electronic device), the metal at the gap-crossing forms a strong coupling with the gap 13, and thus a parasitic capacitor is formed, which may reduce the signal radiation of the antenna radiator 12 at some frequency bands. Descriptions of the parasitic capacitor may be found in the following embodiments, and thus will not be elaborated here.

Fig. 2A is a schematic diagram showing a structure of a metal cover according to an example embodiment, and Fig. 2B is a schematic diagram showing an equivalent circuit of a metal cover according to an example embodiment. As shown in Fig. 2A, there is a gap 13 opened between the metal body 11 and the antenna radiator 12, and there is a first energy storage element 14 electrically connected between the metal body 11 and the antenna radiator 12. The metal body 11 may be regarded as a ground end of the first energy storage element 14, and the antenna radiator 12 may be regarded as a power supply end of the first energy storage element 14.

When the distance between the metal of the USB interface 10 at the gap-crossing and the gap 13 in the thickness direction of the electronic device is less than a predetermined distance (the predetermined distance can be determined by the thickness of the electronic device), the gap-crossing is located at the joint of the USB interface 10 and the gap 13, there exists a strong coupling between the metal of the USB interface 10 at the gap-crossing and the gap 13, and an equivalent parasitic capacitor 20 is formed. With regard to high-frequency signals, the equivalent parasitic capacitor 20 is equivalently grounded at the gap-crossing of the USB interface 10, which may cause the antenna radiator 12 unable to radiate signals normally at some frequency bands.

In this embodiment, with the parallel connection of the first energy storage element 14 and the parasitic capacitor 20, the first energy storage element 14 and the parasitic capacitor 20 form a circuit loop with the metal body 11 and the antenna radiator 12, and the circuit loop may counteract the influence of the parasitic capacitor 20 on the antenna radiator 12, reduce the influence of the parasitic capacitor 20 on the antenna radiator 12 at an operating frequency band and improve the performance of the antenna radiator.

In an embodiment, the first energy storage element is a capacitor or an inductor.

In an embodiment, each of the at least one ground point is electrically connected to the antenna radiator through a wire stretched across the gap.

In an embodiment, there is a second energy storage element electrically connected between each of the at least one ground point and the antenna radiator.

In an embodiment, the position of the at least one ground point on the metal body is determined by the volume of the metal cover, the operating band of the antenna radiator and the capacitance value of the parasitic capacitor between the metal body and the antenna radiator.

In an embodiment, the second energy storage element is a capacitor or an inductor, and each ground point of the at least one ground point is electrically connected to one capacitor or one inductor.

Further structure of the metal cover will be described with reference to the following embodiments.

Thus, with the above metal cover provided by embodiments of the present disclosure, the influence of the parasitic capacitor on the antenna radiator 12 at certain frequency bands may be reduced and the performance of the antenna radiator is improved.

The technical solutions provided by the present disclosure will now be illustrated with reference to individual embodiments.

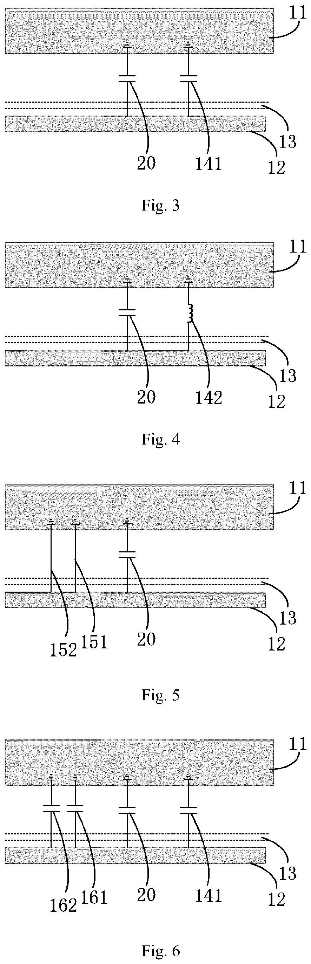

Fig. 3 is a schematic diagram showing an equivalent circuit of a metal cover according to another example embodiment. In this embodiment, the above metal cover provided by embodiments of the present disclosure is utilized, and a capacitor 141 is used as an example of the first energy storage element 14 for exemplary illustration. As shown in Fig. 3, the capacitor 141 is electrically connected between the metal body 11 and the antenna radiator 12.

In an embodiment, Since the capacitance value of the parasitic capacitor 20 is depending on the size of the metal body 11, the opening(s) in the area where the antenna radiator 12 is located and on the like, when the volume of the metal body 11 and the opening(s) in the area where the antenna radiator 12 is located are designed, the range of the capacitance value of the parasitic capacitor 20 is determined, and then the capacitance value of the capacitor 141 is determined by the capacitance of the parasitic capacitor 20.

In this embodiment, by adding the capacitor 141 between the metal body 11 and antenna radiator 12, the capacitance value of the parasitic capacitor 20 may be changed, thus reducing the influence of the parasitic capacitor 20 on the operating band of the antenna radiator 12.

Fig. 4 is a schematic diagram showing an equivalent circuit of a metal cover according to yet another example embodiment. In this embodiment, the above metal cover provided by embodiments of the present disclosure is utilized, and an inductor 142 is used as an example of the first energy storage element 14 for exemplary illustration. As shown in Fig. 4, the inductor 142 is electrically connected between the metal body 11 and the antenna radiator 12.

Similar to the above embodiment in Fig. 3, the capacitance value of the parasitic capacitor 20 is depending on the size of the metal body 11 and the opening(s) in the area where the antenna radiator 12 is located, and thus when the volume of the metal body 11 and the opening(s) in the area where the antenna radiator 12 is located are designed, the range of the capacitance value of the parasitic capacitor 20 is determined, and then the inductance value of the inductor 142 can be determined by the capacitance of the parasitic capacitor 20.

In this embodiment, by adding the inductor 142 between the metal body 11 and antenna radiator 12, the influence of the parasitic capacitor 20 on the operating band of the antenna radiator 12 can be counteracted through the inductor 142.

Fig. 5 is a schematic diagram showing an equivalent circuit of a metal cover according to yet another example embodiment. In this embodiment, the above metal cover provided by embodiments of the present disclosure is utilized, and the metal body 11 having at least one ground point provided thereon is used as an example for exemplary illustration. As shown in Fig. 5, there are at least one ground points provided on the metal body 11. Fig. 5 shows two ground points and the corresponding wire 151 and wire 152, that is, the wire 151 and the wire 152 are connected between the antenna radiator 12 and the metal body 11, and both the wire 151 and the wire 152 are across the gap 13.

In an embodiment, the position of the ground points of the wire 151 and the wire 152 on the metal body 11 is determined by the volume of the metal cover, the operating band of the antenna radiator 12 and the capacitance value of the parasitic capacitor between the metal body 11 and the antenna radiator12. In another embodiment, the position of the ground points of the wire 151 and the wire 152 on the metal body 11 may be determined after the debugging of the electronic device.

In the structure of the metal cover of this embodiment, with the parallel connection of the wire 151 and the wire 152, and with the circuit loop formed by the wire 51, the wire 52, the metal body 11 and the antenna radiator 12, the influence of the parasitic capacitor 20 on the antenna radiator 12 in the operating band can be changed.

Fig. 6 is a schematic diagram showing an equivalent circuit of a metal cover according to yet another example embodiment. In this embodiment, the above metal cover provided by embodiments of the present disclosure is utilized, and a capacitor 161 and a capacitor 162 are used as an example of the second energy storage element for exemplary illustration. As shown in Fig. 6, there are also ground points corresponding to the capacitor 161 and the capacitor 162 on the metal body 11, and the capacitor 161 and the capacitor 162 are electrically connected to the corresponding ground points respectively.

In an embodiment, the ground points on the metal body 11 may be connected to the metal body 11 by means of elastic slices. In an embodiment, the capacitor 161 and the capacitor 162 may be electrically connected at the gap 13 directly.

In an embodiment, the position of the ground points corresponding to the capacitor 161 and the capacitor 162 on the metal body 11 is determined by the volume of the metal cover, the operating band of the antenna radiator 12 and the capacitance of the parasitic capacitor between the metal body 11 and the antenna radiator 12, or may be determined through experiments.

In the structure of the metal cover of this embodiment, with the parallel connection of the capacitor 141, the capacitor 161 and the capacitor 162, and with the circuit loop formed by the capacitor 141, the capacitor 161, the capacitor 162, the metal body 11 and the antenna radiator 12, the influence of the parasitic capacitor 20 on the antenna radiator 12 in the operating band can be changed.

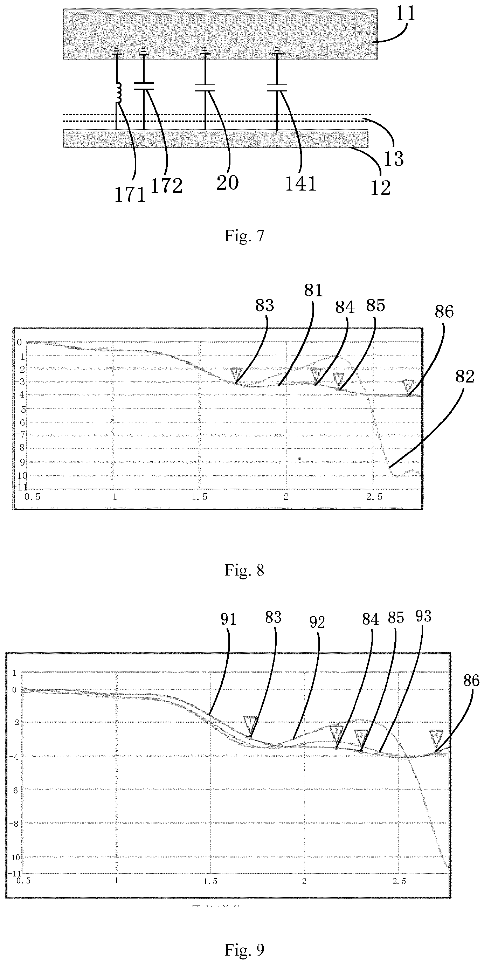

Fig. 7 is a schematic diagram showing an equivalent circuit of a metal cover according to yet another example embodiment. In this embodiment, the above metal cover provided by embodiments of the present disclosure is utilized, and an inductor 171 and a capacitor 172 are used as an example of the second energy storage element for exemplary illustration. As shown in Fig. 7, there are also ground points corresponding to the inductor 171 and the capacitor 172 on the metal body 11, and the inductor 171 and the capacitor 172 are electrically connected to the corresponding ground points respectively.

In an embodiment, the ground points on the metal body 11 may be connected to the metal body 11 by means of elastic slices. In an embodiment, the inductor 171 and the capacitor 172 may be electrically connected at the gap 13 directly.

In an embodiment, the position of the ground points corresponding to the inductor 171 and the capacitor 172 on the metal body 11 is determined by the volume of the metal cover, the operating band of the antenna radiator 12 and the capacitance value of the parasitic capacitor between the metal body 11 and the antenna radiator 12, or may be determined through experiments.

In the structure of the metal cover of this embodiment, with the parallel connection of the capacitor 141, the inductor 171 and the capacitor 172, and with the circuit loop formed by the capacitor 141, the inductor 171, the capacitor 172, the metal body 11 and the antenna radiator 12, the influence of the parasitic capacitor 20 on the antenna radiator 12 in the operating band can be changed.

It should be understood by those skilled in the art that, the number of the ground points and the number of the inductors or capacitors shown in Fig. 2A to Fig. 7 are merely exemplary for illustration, and the number of inductors and/or capacitors and the number of the ground points shown in Fig. 2A to Fig. 7 shall not be constructed as any limits to the present disclosure. The number of inductors and/or capacitors and the number of ground points can be set according to actual requirements such as the volume of the electronic device, the size of the gap and opening(s), so as to eliminate the influence of the parasitic capacitor on the antenna radiator.

Fig. 8 is a schematic diagram showing performance curves of the antenna when the present disclosure is not used according to an example embodiment. Fig. 9 is a schematic diagram showing performance curves of the antenna when the present disclosure is used according to an example embodiment. In the graphs shown in Fig. 8 and Fig. 9, the lateral axis represents the frequency, and the vertical axis represents the antenna return loss S11 (in DB). As shown in Fig. 8, when there is a USB interface 10 in an electronic device, and the wiring of the USB interface 10 stretches across the gap 13, the antenna return loss S11 in middle-frequency band bulges (shown as curve 82), and the radiating capability of the antenna drops clearly. Curve 81 shows a schematic view of the antenna efficiency when there is no USB interface in the electronic device. Reference number 83 corresponds to a frequency of 1710MHz, reference number 84 corresponds to a frequency of 2170MHz, reference number 85 corresponds to a frequency of 2300MHz, and reference number 86 corresponds to a frequency of 2700MHz.

When one ground point is added on the metal body 11 and the ground point is electrically connected to the antenna radiator 12 directly through a wire, the efficiency of the antenna is shown as the curve with reference number 91. The curve with reference number 93 schematically represents the efficiency of the antenna when there is no USB interface in the antenna radiator 12, and the curve with reference number 92 schematically represents the efficiency of the antenna when there is a USB interface in the antenna radiator 12 and the solutions according to the present disclosure are not used. It can be seen from Fig. 9 that, by adding one ground point on the metal body 11 and by electrically connecting the ground point to the antenna radiator 12 through a wire directly, the influence of the parasitic capacitor formed by the USB interface on the middle-frequency band can be eliminated. Those skilled in the art should understand that, Fig. 9 only shows advantageous effects corresponding to adding one ground point on the metal body 11, and by adding different number of ground points on the metal body 11, and by adding different combinations of capacitors and/or inductors between the ground points and the antenna radiator, influences of the parasitic capacitor on different frequency bands may be eliminated.

The influences on middle-frequency band signals are used as an example in the above embodiments. However, in some circumstances, because of the existence of the parasitic capacitor, the signals in high-frequency bands or low-frequency bands may also be influenced. By adding different number of ground points at different locations between the metal body 11 and the antenna radiator 12 and by loading different capacitors, inductors or direct short circuit at the ground points, the influences of the parasitic capacitor on different frequency bands may be eliminated.

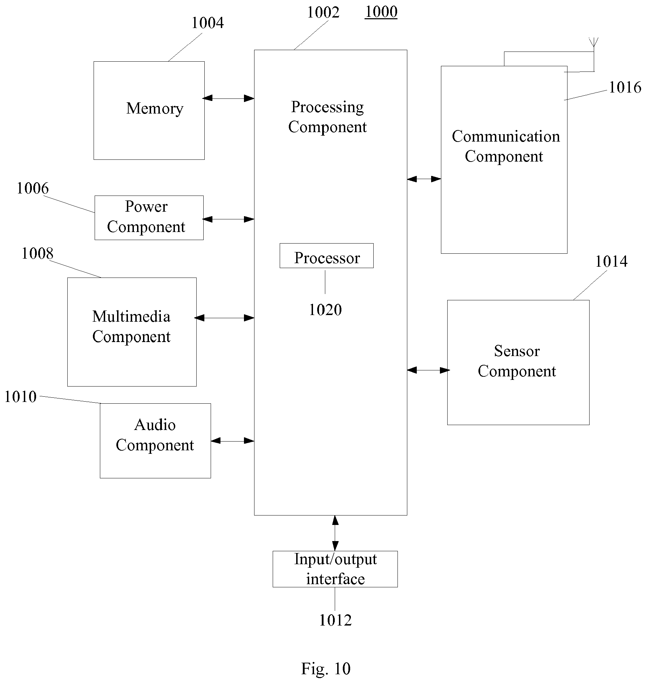

Fig. 10 is a block diagram showing an electronic device according to an example embodiment. For example, the device 1000 could be an electronic device such as a mobile phone having a camera, a computer, a digital broadcast terminal, a messaging device, a gaming console, a tablet, a medical device, an exercise equipment, a personal digital assistant and the like.

In detail, the electronic device includes a metal cover and the metal cover may be any one of the metal covers illustrated in above Fig. 2A to Fig. 7. The metal cover includes a metal body 11 and an antenna radiator 12, a gap 13 is opened between the metal body 11 and the antenna radiator 12, at least one ground point is provided on the metal body 11, and the antenna radiator 12 is electrically connected to at least one ground point.

In an embodiment, there is a first energy storage element electrically connected between the metal body 11 and the antenna radiator 12.

In an embodiment, a parameter of the first energy storage element is determined by a capacitance of the parasitic capacitor between the metal body and the antenna radiator.

With reference to Fig. 10, the device 1000 may include one or more of the following components: a processing component 1002, a memory 1004, a power component 1006, a multimedia component 1008, an audio component 1010, an input/output (I/O) interface 1010, a sensor component 1014, and a communication component 1016.

The processing component 1002 typically controls overall operations of the device 1000, such as the operations associated with display, telephone calls, data communications, camera operations, and recording operations. The processing component 1002 may include one or more processors 1020 to execute instructions to perform all or part of the steps in the above -described methods. Moreover, the processing component 1002 may include one or more modules which facilitate the interaction between the processing component 1002 and other components.. For instance, the processing component 1002 may include a multimedia module to facilitate the interaction between the multimedia component 1008 and the processing component 1002.

The memory 1004 is configured to store various types of data to support the operation of the device 1000. Examples of such data include instructions for any applications or methods operated on the device 1000, contact data, phonebook data, messages, pictures, videos, etc. The memory 1004 may be implemented using any type of volatile or non-volatile memory devices, or a combination thereof, such as a static random access memory (SRAM), an electrically erasable programmable read-only memory (EEPROM), an erasable programmable read-only memory (EPROM), a programmable read-only memory (PROM), a read-only memory (ROM), a magnetic memory, a flash memory, a magnetic or optical disk.

The power component 1006 provides power to various components of the device 1000. The power component 1006 may include a power management system, one or more power sources, and any other components associated with the generation, management, and distribution of power in the device 1000.

The multimedia component 1008 includes a screen providing an output interface between the device 1000 and the user. In some embodiments, the screen may include a liquid crystal display (LCD) and a touch panel (TP). If the screen includes the touch panel, the screen may be implemented as a touch screen to receive input signals from the user. The touch panel includes one or more touch sensors to sense touches, swipes, and gestures on the touch panel. The touch sensors may not only sense a boundary of a touch or swipe action, but also sense a period of time and a pressure associated with the touch or swipe action. In some embodiments, the multimedia component 1008 includes a front camera and/or a rear camera. The front camera and the rear camera may receive an external multimedia datum while the device 1000 is in an operation mode, such as a photographing mode or a video mode. Each of the front camera and the rear camera may be a fixed optical lens system or have focus and optical zoom capability.

The audio component 1010 is configured to output and/or input audio signals. For example, the audio component 1010 includes a microphone (MIC) configured to receive an external audio signal when the device 1000 is in an operation mode, such as a call mode, a recording mode, and a voice recognition mode. The received audio signal may be further stored in the memory 1004 or transmitted via the communication component 1016. In some embodiments, the audio component 1010 further includes a speaker to output audio signals.

The I/O interface 1010 provides an interface between the processing component 1002 and peripheral interface modules, such as a keyboard, a click wheel, buttons, and the like. The buttons may include, but are not limited to, a home button, a volume button, a starting button, and a locking button.

The sensor component 1014 includes one or more sensors to provide status assessments of various aspects of the device 1000. For instance, the sensor component 1014 may detect an open/closed status of the device 1000, relative positioning of components, e.g., the display and the keypad, of the device 1000, a change in position of the device 1000 or a component of the device 1000, a presence or absence of user contact with the device 1000, an orientation or an acceleration/deceleration of the device 1000, and a change in temperature of the device 1000. The sensor component 1014 may include a proximity sensor configured to detect the presence of nearby objects without any physical contact. The sensor component 1014 may also include a light sensor, such as a CMOS or CCD image sensor, for use in imaging applications. In some embodiments, the sensor component 1014 may also include an accelerometer sensor, a gyroscope sensor, a magnetic sensor, a pressure sensor, or a temperature sensor.

The communication component 1016 is configured to facilitate communication, wired or wirelessly, between the device 1000 and other devices. The device 1000 can access a wireless network based on a communication standard, such as WIFI, 2G, or 3G, or a combination thereof. In one exemplary embodiment, the communication component 1016 receives a broadcast signal or broadcast associated information from an external broadcast management system via a broadcast channel. In one exemplary embodiment, the communication component 1016 further includes a near field communication (NFC) module to facilitate short-range communications. For example, the NFC module may be implemented based on a radio frequency identification (RFID) technology, an infrared data association (IrDA) technology, an ultra-wide band (UWB) technology, a Bluetooth (BT) technology, and other technologies.

In exemplary embodiments, the device 1000 may be implemented with one or more application specific integrated circuits (ASICs), digital signal processors (DSPs), digital signal processing devices (DSPDs), programmable logic devices (PLDs), field programmable gate arrays (FPGAs), controllers, micro-controllers, microprocessors, or other electronic components.

## Claims

1. A metal cover, comprising:
a metal body (11) and an antenna radiator (12),
a gap (13) provided between the metal body (11) and the antenna radiator (12),
at least one ground point being provided on the metal body (11), and the antenna radiator (12) being electrically connected to the at least one ground point, and
an opening formed in an area where the antenna radiator (12) is located and configured for receiving a metallic component (10) of an electronic device, wherein when the metal cover is assembled to the electronic device, the metallic component (10) is located inside the metal cover and at a distance from the gap (13) to form a gap-crossing at the gap (13), such that a parasitic capacitor (20) is formed,
wherein a first energy storage element (14), a second energy storage element and/or a wire stretched across the gap is disposed between a respective one of the at least one ground point and the antenna radiator (12) so as to reduce the influence of the parasitic capacitor (20) on an operating band of the antenna radiator, and
each of the first energy storage element (14), the second energy storage element and/or the wire is directly electrically connected between a respective one of the at least one ground point and the antenna radiator (12).

2. The cover according to claim 1, wherein any combination of the first energy storage element (14), the second energy storage element, and the wire stretched across the gap are parallelly connected with each other.

3. The cover according to claim 1 or 2, wherein, a parameter of the first energy storage element (14) is determined by a capacitance value of a parasitic capacitor (20) between the metal body and the antenna radiator.

4. The cover according to any one of claims 1 to 3, wherein, the first energy storage element (14) is a capacitor (141) or an inductor (142).

5. The cover according to claim 1, wherein, the second energy storage element is a capacitor (161) or an inductor (171), and the capacitor (161) or the inductor (171) is electrically connected to a respective one of the at least one ground point and the antenna radiator (12).

6. The cover according to any one of claims 1 to 5, wherein the metallic component (10) is a USB interface or a fingerprint identification sensor.

7. An electronic device, comprising:
a processor;
a memory for storing instructions executable by the processor; and
a metal cover, according to any one of claims 1-6.

## Patentansprüche

1. Metallabdeckung, die aufweist:
einen Metallkörper (11) und einen Antennenstrahler (12),
einen Spalt (13), der zwischen dem Metallkörper (11) und dem Antennenstrahler (12) vorgesehen ist,
wobei mindestens ein Erdungspunkt auf dem Metallkörper (11) vorgesehen ist und der Antennenstrahler (12) mit dem mindestens einen Erdungspunkt elektrisch verbunden ist, und
eine Öffnung, die in einem Bereich ausgebildet ist, in dem sich der Antennenstrahler (12) befindet, und die zum Aufnehmen einer metallischen Komponente (10) einer elektronischen Vorrichtung ausgebildet ist, wobei sich dann, wenn die Metallabdeckung an der elektronischen Vorrichtung angebracht ist, die metallische Komponente (10) innerhalb der Metallabdeckung und in einem Abstand zu dem Spalt (13) befindet, um einen Spaltübergang an dem Spalt (13) zu bilden, so dass ein parasitärer Kondensator (20) gebildet wird,
wobei ein erstes Energiespeicherelement (14), ein zweites Energiespeicherelement und/oder ein Draht, der über den Spalt gespannt ist, zwischen einem jeweiligen einen des mindestens einen Erdungspunkts und des Antennenstrahlers (12) angeordnet ist, um den Einfluss des parasitären Kondensators (20) in einem Betriebsband des Antennenstrahlers zu verringern, und
jedes des ersten Energiespeicherelements (14), des zweiten Energiespeicherelements und/oder des Draht zwischen einem jeweiligen einen des mindestens einen Erdungspunkts und des Antennenstrahlers (12) direkt elektrisch verbunden ist.

2. Abdeckung nach Anspruch 1, bei der jede Kombination aus dem ersten Energiespeicherelement (14), dem zweiten Energiespeicherelement und dem Draht, der über den Spalt gespannt ist, zueinander parallelgeschaltet sind.

3. Abdeckung nach Anspruch 1 oder 2, bei der ein Parameter des ersten Energiespeicherelements (14) durch einen Kapazitätswert eines parasitären Kondensators (20) zwischen dem Metallkörper und dem Antennenstrahler bestimmt wird.

4. Abdeckung nach einem der Ansprüche 1 bis 3, bei der das erste Energiespeicherelement (14) ein Kondensator (141) oder eine Induktivität (142) ist.

5. Abdeckung nach Anspruch 1, bei der das zweite Energiespeicherelement ein Kondensator (161) oder eine Induktivität (171) ist und der Kondensator (161) oder die Induktivität (171) mit einem jeweiligen einen des mindestens einen Erdungspunkts und des Antennenstrahlers (12) elektrisch verbunden ist.

6. Abdeckung nach einem der Ansprüche 1 bis 5, bei der die metallische Komponente (10) eine USB-Schnittstelle oder ein Fingerabdruck-Identifikationssensor ist.

7. Elektrische Vorrichtung, die aufweist:
einen Prozessor;
einen Speicher zum Speichern von Anweisungen, die durch den Prozessor ausführbar sind; und
eine Metallabdeckung nach einem der Ansprüche 1-6.

## Revendications

1. Couvercle métallique, comprenant :
un corps métallique (11) et un radiateur d'antenne (12),
un espace (13) prévu entre le corps métallique (11) et le radiateur d'antenne (12),
au moins un point de masse étant prévu sur le corps métallique (11), et le radiateur d'antenne (12) étant connecté électriquement à l'au moins un point de masse, et
une ouverture formée dans une zone où le radiateur d'antenne (12) est situé et configuré pour recevoir un composant métallique (10) d'un dispositif électronique, dans lequel lorsque le couvercle métallique est assemblé au dispositif électronique, le composant métallique (10) est situé à l'intérieur du couvercle métallique et à distance de l'interstice (13) pour former un croisement espacé au niveau de l'interstice (13), de telle sorte qu'un condensateur parasite (20) est formé,
dans lequel un premier élément de stockage d'énergie (14), un second élément de stockage d'énergie et/ou un fil tendu à travers l'espace est disposé entre un point respectif parmi l'au moins un point de masse et le radiateur d'antenne (12) de manière à réduire l'influence du condensateur parasite (20) sur une bande de fonctionnement du radiateur d'antenne, et
chacun du premier élément de stockage d'énergie (14), du second élément de stockage d'énergie et/ou du fil est directement connecté électriquement entre un point respectif parmi l'au moins un point de masse et le radiateur d'antenne (12).

2. Couvercle selon la revendication 1, dans lequel une quelconque combinaison du premier élément de stockage d'énergie (14), du second élément de stockage d'énergie et du fil tendu à travers l'interstice sont connectés parallèlement l'un à l'autre.

3. Couvercle selon la revendication 1 ou 2, dans lequel, un paramètre du premier élément de stockage d'énergie (14) est déterminé par une valeur de capacité d'un condensateur parasite (20) entre le corps métallique et le radiateur d'antenne.

4. Couvercle selon l'une quelconque des revendications 1 à 3, dans lequel, le premier élément de stockage d'énergie (14) est un condensateur (141) ou un inducteur (142).

5. Couvercle selon la revendication 1, dans lequel le second élément de stockage d'énergie est un condensateur (161) ou un inducteur (171), et le condensateur (161) ou l'inducteur (171) est connecté électriquement à un condensateur respectif parmi l'au moins un point de masse et le radiateur d'antenne (12).

6. Couvercle selon l'une quelconque des revendications 1 à 5, dans lequel le composant métallique (10) est une interface USB ou un capteur d'identification d'empreinte digitale.

7. Dispositif électronique, comprenant :
un processeur ;
une mémoire pour stocker des instructions exécutables par le processeur ; et
un couvercle métallique, selon l'une quelconque des revendications 1 à 6.
